# EUROPEAN PATENT APPLICATION

(11) **EP 3 016 148 A1**
(43) Date of publication of application: **04.05.2016**
(21) Application number: 14190752.7
(22) Date of filing: 28.10.2014
(51) Int. Cl.: H01L 31/0236, H01L 31/0352, H01L 31/0687, H01L 31/0693, H01L 31/0725, H01L 31/078, H01L 31/043

(54) **Dual layer photovoltaic device**

(71) Applicant: Sol Voltaics AB, 223 63 Lund (SE)
(72) Inventor: Aberg, Ingvar, 245 32 Staffanstorp (SE); Björk, Mikael, 234 37 Lomma (SE); Sauar, Erik, N-0372 Oslo (NO); Samuelson, Lars, 211 19 Malmö (SE); Ohlsson, Jonas, 21213 Malmö (SE)
(74) Representative: Neij & Lindberg AB

(57) **Abstract**

A hybrid photovoltaic device (1) comprises a thin film solar cell (2) disposed in a first layer (21), having a junction with a first band gap corresponding to a first spectral range; and a bulk solar cell (3) disposed in a second layer (31), positioned below the first layer (21), having a junction with a second band gap, which is smaller than said first band gap and corresponding to a second spectral range. The thin film solar cell (2) may be partly transparent to light within said first spectral range.

## Description

### Technical field

The present invention relates to the field of photovoltaic devices for use as solar cells, and in particular to a double cell structure arranged in layers.

### Background

When it comes to the principal design, the market for solar cells is currently dominated by two different technologies.

The most prevalent technology is bulk solar cells, where the dominating bulk material is crystalline silicon (Si). The bulk material may e.g. be monocrystalline silicon or poly- or multicrystalline silicon, and may be provided in cylindrical wafer form or cast from square or pseudo-square ingots. Si based bulk solar cells benefit from technological maturity, as well as low raw material cost and toxicity.

The other technology is thin film solar cells, which are typically made by depositing one or more thin layers (thin film) of photovoltaic material on a substrate. The film thickness varies from a few nanometers to tens of micrometers, and is thus substantially thinner than e.g. a Si wafer. Thin film materials used include cadmium telluride (CdTe), copper indium gallium selenide solar cells (CIS or CIGS), amorphous silicon (a-Si) and other thin-film Si cells. Thin film solar cells have the advantage of not being limited by wafer form factors, and can thus be made in large sheets. Compared to Si-based solar cells, thin film technologies also offer cost benefits due to low material consumption.

One reason for investigating other technologies than the dominating Si bulk type solar cells is that the band gap of crystalline Si is about 1.1 eV, which corresponds to absorption in the near infrared spectral region and an open circuit voltage (V_{OC}) of about 0.7 V. The sun, however, is an approximate black-body radiator with an emission spectrum peaked in the yellow-green part of the visible spectrum. This means that most photons have higher energy than the Si band gap, but the cell will still only generate 0.7 V voltage. By manufacturing thin film cells from suitable materials having a higher band gap, an increased V_{OC} can be reached. One example is III-V energy materials, such as GaAs with a direct band gap of 1.43 eV, rendering an output voltage of about 1.1 V.

In an attempt to overcome the problem of matching the absorption of the solar cell with the emission spectrum of the sun, multi-junction thin film solar cells with multiple p-n junctions made of different semiconductor materials have been developed. In such a multi-layer device, each material's p-n junction will produce electric current in response to a different wavelength of light, which allows absorption of a broader range of wavelengths, thereby improving the cell's energy conversion efficiency. However, this efficiency is gained at the cost of increased complexity and manufacturing price, and frequently the dependence on availability of rare elements.

### Summary of the invention

It is realized that there is room for improvement in the field of solar cells, in particular with respect to obtaining a reasonable energy conversion efficiency at a reasonable cost. This object is fulfilled by means of a solar cell according to the independent claim 1. Further details of preferred embodiments are listed in the dependent claims.

According to one aspect, the invention relates to a hybrid photovoltaic device comprising a thin film solar cell disposed in a first layer, having a junction with a first band gap corresponding to a first spectral range; a bulk solar cell disposed in a second layer, positioned below the first layer, having a junction with a second band gap, which is smaller than said first band gap and corresponding to a second spectral range.

In one embodiment, said thin film solar cell is at least partly transparent to light within said first spectral range.

In one embodiment, said first layer comprises absorbing regions and non-absorbing regions, such that a portion of an incident photonic wave-front will pass through the non-absorbing region to the second layer.

In one embodiment, said portion of the incident photonic wave-front is dependent on a lateral density of the absorbing regions.

In one embodiment, said first layer is configured to have a predetermined level of transparency to light of said first spectral range.

In one embodiment, the thin film solar cell is serially connected to the bulk solar cell through a galvanic connection between a thin film electrode and a bulk electrode.

In one embodiment, the thin film solar cell has a level of transparency to light of the first spectral range configured so as to contribute to photocurrent matching between the thin film solar cell and the bulk material solar cell.

In one embodiment, said thin film solar cell is partitioned throughout the first layer so as to obtain said level of transparency.

In one embodiment, said thin film solar cell is a nanowire solar cell comprising an array of vertically aligned nanowires.

In one embodiment, a surface density of nanowires is limited so as to obtain said level of transparency.

In one embodiment, the material of the nanowires in the film cell is a direct band gap semiconductor such as, GaAs, AlGaAs, InP, or alloys thereof.

In one embodiment, the bulk solar cell is made of Si.

In one embodiment, the first band gap is adjusted so as to contribute to photocurrent matching between the thin film solar cell and the bulk solar cell.

In one embodiment, said galvanic connection also connects to an electrode of a second bulk solar cell such that said bulk solar cells are connected in parallel to each other and in series to said thin film solar cell, so as to contribute to the photocurrent matching between the thin film solar cell and the bulk solar cells.

In one embodiment, a first number of thin film solar cells are serially interconnected into a first string of thin film cells, and a second number of bulk solar cells are serially interconnected into a second string of bulk solar cells, which first and second strings are connected in parallel, and wherein said numbers of cells in the strings are adapted so as to contribute to voltage matching.

In one embodiment, the hybrid photovoltaic comprises a conductive layer positioned between the first layer and the second layer, galvanically connecting an electrode of the thin film solar cell with an electrode of the bulk solar cell.

In one embodiment, a first connector grid structure is connected at an upper face of the thin film solar cell, and wherein said galvanic connection comprises a second grid structure, and wherein said first and second grid structures substantially overlap vertically.

In one embodiment, said grid structure is positioned between the first layer and the second layer, common for the thin film solar cell and the bulk material solar cell.

It will be evident to the skilled reader that the embodiments listed above, and outlined in further detail below, may be combined in various ways.

### Brief description of the drawings

Embodiments of the invention will be described below with reference to the accompanying drawings, in which
Fig. 1 shows a general embodiment of the invention, including a thin film solar cell arranged over a bulk solar cell;
Fig. 2 illustrates an embodiment with serially connected thin film cells disposed over serially connected bulk solar cells;
Fig. 3 illustrates a top view of an upper layer of thin film solar cells, according to the embodiment of Fig. 2;
Fig. 4 illustrates a top view of a lower layer of bulk solar cells, according to the embodiment of Fig. 2;
Fig. 5 shows an embodiment of a tandem cell, in which thin film cell has direct galvanic, ohmic, connection to the underlying bulk cell 3;
Fig. 6 illustrates a module of serially connected tandem cells according to Fig. 5;
Figs 7a-d illustrate embodiments of photovoltaic devices configured in different electrical connection arrangements; and
Fig. 8 illustrates an embodiment indicating partial transparency in the thin film solar cell layer, to light of frequencies higher than its band gap.

### Detailed description of embodiments

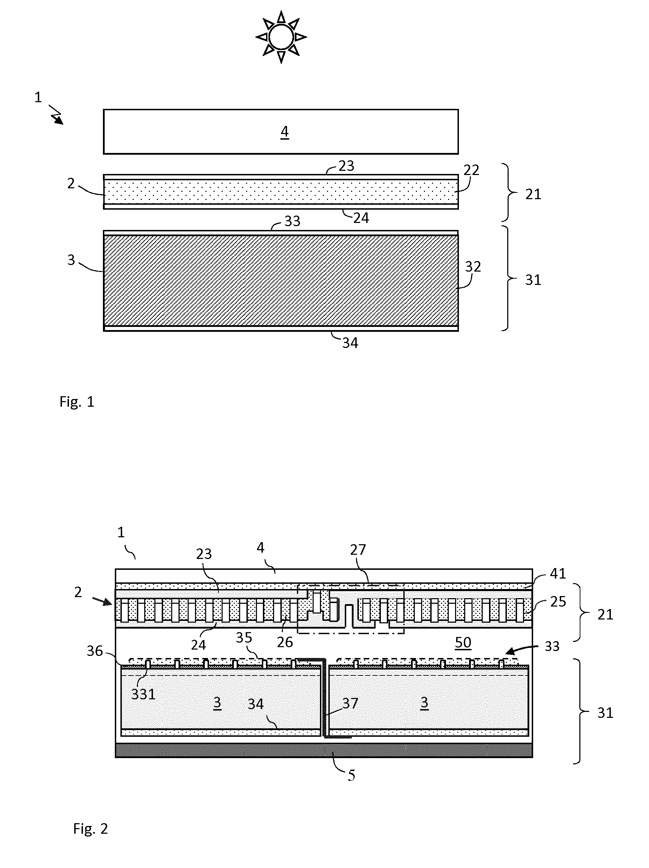

Fig. 1 schematically illustrates a general configuration for a hybrid photovoltaic device 1 according to an embodiment of the invention. The device 1 includes at least two cells 2, 3 configured for photoelectric conversion, arranged in two different layers 21, 22. A thin film solar cell 2 is disposed in a first layer 21, which is configured to be arranged closes to the sun. The thin film solar cell 2 comprises at least one junction with a first band gap corresponding to a first spectral range. A bulk solar cell 3 is disposed in a second layer 31, positioned below the first layer 21, i.e. configured to be arranged furthest from the sun of the two layers 21, 31. The bulk solar cell 3 includes at least one junction having a second band gap, being smaller than the first band gap of the first layer, and corresponding to a second spectral range. Furthermore, the thin film solar cell 2 is at least partly transparent to light within the second spectral range. A protective transparent cover 4 may also be included, such as a glass substrate.

While the first layer 21 may include more than one thin film solar cell, the illustrated at least one thin film solar cell 2 may comprise a film of active photovoltaic material layer 22, where carrier generation is configured to occur upon absorption of photons, sandwiched between two electrodes 23, 24. While further details are not shown in this drawing, it will be understood by the skilled reader that the photovoltaic material layer 22 may include an upper n-type layer formed by a first semiconductor material, and a lower p-type absorption layer formed by a second semiconductor material. A junction is formed between the n-type and p-type materials, having said first band gap. In addition, the thin film solar cell 2 may include antireflection coatings. The electrodes 23, 24 are at least partly transparent to light. One example of such an electrode is Transparent Conducting Films (TCF), which are optically transparent and electrically conductive, arranged in thin layers. As an example, the film may include a layer of transparent conducting oxide (TCO), e.g. in the form of indium tin oxide (ITO), fluorine doped tin oxide (FTO), and doped zinc oxide. Other type of TCFs are known, e.g. organic films including graphene or carbon nanotubes. A TCF may be employed for the upper electrode 23, for the lower electrode 24, or both. Another alternative for the electrodes is a fine grid of electrically conductive material, such as a metal, configured to have minimal shading effect.

The bulk solar cell 3 is preferably made from a Si bulk material 32, though other materials are plausible such as copper indium gallium selenide (CIGS). The bulk solar cell may be stiff or also be a flexible film. Consequently, while the following description predominantly provides examples related to a Si bulk cell 3, the skilled person will understand that unless contradictory, the bulk cell 3 of those embodiments may alternatively be made of CIGS or other suitable bulk material. The bulk band gap of the bulk solar cell 3 may be at least 0.2 eV lower, preferably at least 0.3eV lower, than the band gap of a thin film solar cell 2 disposed over the bulk solar cell 3, as discussed below. A Si bulk solar cell may be formed by crystalline silicon (c-Si), such as monocrystalline Si, or by polycrystalline or multicrystalline Si. The bulk material has a p-doped portion and an n-doped portion, whereby a p-n junction is formed between the doped portions. Commonly, the p-n junction is formed near a surface of the substrate which receives impinging radiation, i.e. its upper surface in Fig. 1, and may extend throughout the bulk material layer 31. Electrodes 33 and 34 may thus be connected to the upper and lower surfaces of the bulk material cell 3. As for the thin film cell 2, the electrodes 33, 34 may be provided by means of TFs, or by ohmic contacts of metal wires. However, alternative embodiments are available. In US 4,234,352 a photovoltaic cell is instead proposed, in which a plurality of p and n doped regions are formed in the substrate at the surface facing away from the sun in alternating conductivity rows. This way, both electrodes 33, 34 may be attached to the lower side of the bulk material 32 in layer 31. It will thus be understood by the reader that the representation of the electrodes 33, 34 as in Fig. 1 is merely schematic. A reflective layer may furthermore be provided on the lower surface, so as to reflect non-absorbed light back into the cell 3.

A general problem related to solar cells is that only photons having at least a minimum energy level can generate an electron-hole pair in the semiconductor material. Photons having less energy are either not absorbed or are absorbed as heat, and the excess energy of photons having more energy, i.e. photons having a longer wavelengths, creates heat. These and other losses limit the efficiency of photovoltaic cells in directly converting solar radiation to electricity. Attempts at increasing the conversion efficiency have therefore been made by means of stacking different layers of thin film solar cells with different band gaps. Amorphous silicon (a-Si) is a non-crystalline, allotropic form of silicon, which is a well-developed thin film technology. It has a higher bandgap (1.7 eV) than crystalline silicon (c-Si) (1.1 eV), which means it absorbs the visible part of the solar spectrum more strongly than the higher energy infrared portion of the spectrum. A layer of a-Si can be combined with layers of other allotropic forms of Si to produce a multijunction photovoltaic cell. By stacking these layers on top of one other, a broader range of the light spectra is absorbed, more photons are captured, improving the cell's overall efficiency. In the example of micromorphous silicon, a layer of a-Si is combined with a layer of nanocrystalline Si creating a tandem cell. The top a-Si layer absorbs the visible light, leaving the infrared part to the bottom nanocrystalline c-Si layer. However, a-Si cells suffer from significant output loss from sun exposure due to the Staebler-Wronski effect. Thinner layers may increase the electric field strength across the material, reducing degradation but also light absorption/efficiency. Tandem, or multijunction, cells of this type are normally electrically separate. A more complex design is the monolithically integrated cell, where the thin film solar cell consists of a number of layers that are both mechanically and electrically connected.

The embodiment described with reference to Fig. 1 differs from the mentioned state of the art designs, in that it combines a thin film solar cell 2 for higher frequencies in the first spectral range, with a bulk type solar cell 3 for lower frequencies in the second spectral range, wherein the first layer 21 is at least partly transparent to light within said second spectral range. This makes it possible to make use of the more affordable bulk type solar cell, but to provide improvement in terms of total energy conversion by means of a thin film solar cell rather than designing a complete multijunction thin film cell from scratch. In addition, it will be possible to improve existing installations of bulk cells by adding a thin film solar cell layer 21 on top, e.g. by adhering it to a front glass of such a bulk cell installation, with very limited assembly cost.

Fig. 2 illustrates a more specific example falling within the scope of the general embodiment of Fig. 1. In this embodiment, a top nanowire array based thin film solar cell 2 is arranged in the upper layer 21, on top of lower layer 31 comprising a bottom bulk Si cell 3. Each layer may comprise one or more cells 2 and 3, respectively. In the illustrated embodiment, upper layer 21 comprises an array of nanowires 25 segmented into two segments 2, connected by means of a series connection 27 to form a top module. This makes it possible to regulate the current in the top module. Correspondingly, two separate Si bulk solar cells 3 are shown in layer 31, serially connected by means of a conductive wiring 37 and forming a bottom module.

Each nanowire 25 comprises at least one semiconductor junction, and is connected on one side of the junction to the top transparent electrode 23, and on the other side to the bottom transparent electrode 24. The top and bottom transparent electrodes 23, 24 are separated by an insulating dielectric 26 such as silicon oxide. The top electrode 23 of the top module is attached to transparent substrate 4, such as glass, via an adhesive or other transparent layers 41.

In the bottom module of the lower layer 31, each Si bulk cell 3 comprises at least one junction (dashed in the drawing). One side of the junction may be contacted by a continuous or a grid-structured electrode 33, and the other side may be contacted by another continuous or grid-structured electrode 34. As outlined with reference to Fig. 1, the junction may have a different geometry than shown here, in which case the electrodes 33, 34 may both be placed on one side of the cell. At least one surface of the Si cell 3 may be passivated by a dielectric layer 36 such as SiNx, e.g. stoichiometric Si₃N₄. Other components of the cell may vary in detail. In the embodiment shown, the upper one electrode 33 is made of grid-like fingers 331, which are interconnected by means of a bus bar 35. In this embodiment, the rear electrode 34 is continuous.

The stacked device 1 may further include a rear substrate or backing layer 5 made of e.g. glass, PET, steel, or other, preventing e.g. moisture, oxygen, and salt from entering the module and causing degradation. Furthermore, an adhesive 50, e.g. a copolymer such as EVA (Ethylene vinyl acetate), is included to fill the space between the upper and lower modules and attaching the two together. EVA may also be employed for filling the space between the lower cell 3 and the rear substrate 5 as well as in between the top cell 2 and the top glass cover 4 forming as hermetically sealed stacked package. It should also be noted that the drawings are not to scale.

The top nanowire cell 2 may comprise a periodic or aperiodic array of vertically aligned semiconductor nanowires 25 made of e.g. GaAs, AlGaAs, InP, or alloys thereof. The nanowires 25 may be partitioned by a non-conducting dielectric 26 such as a polymer, which is transparent to most of the solar spectrum. The nanowires 25 may typically be between 100-250 nm or, preferably, between 130-200 nm in diameter, and 1-3 micrometers in length. The nanowires 25 may be positioned in the array with a center-center spacing in the range of 300-800 nm. Each single nanowire comprises at least one p-n junction, and the nanowires are aligned in such a way that each wire has the same polarity; e.g. with an n-type emitter of each wire is facing the sun. Both the top and bottom (n and p type) parts of the nanowires are connected to the mentioned transparent electrodes 23 and 24, respectively. The top transparent electrode 23 may be a transparent conducting oxide such as ITO and the thickness may be in the range of 30-300 nm. The top transparent electrode 23 may further be attached to the transparent cover 4, which may be of glass, via an adhesive or other transparent layers 41. The segmentation illustrated at the interconnection 27 may be formed using a series of laser, and mechanical scribes. This way the top part of nanowires 25 within a first segment may be connected to the lower part of the nanowires 25 in a second neighboring segment, via the two layers of transparent electrodes 23, 24. The lower transparent electrode 24, connecting to the bottom part of the nanowires 25, may be of the same material as the topmost transparent electrode 23 but may equally well consist of a differing transparent conductor material, e.g. Aluminum doped Zinc oxide.

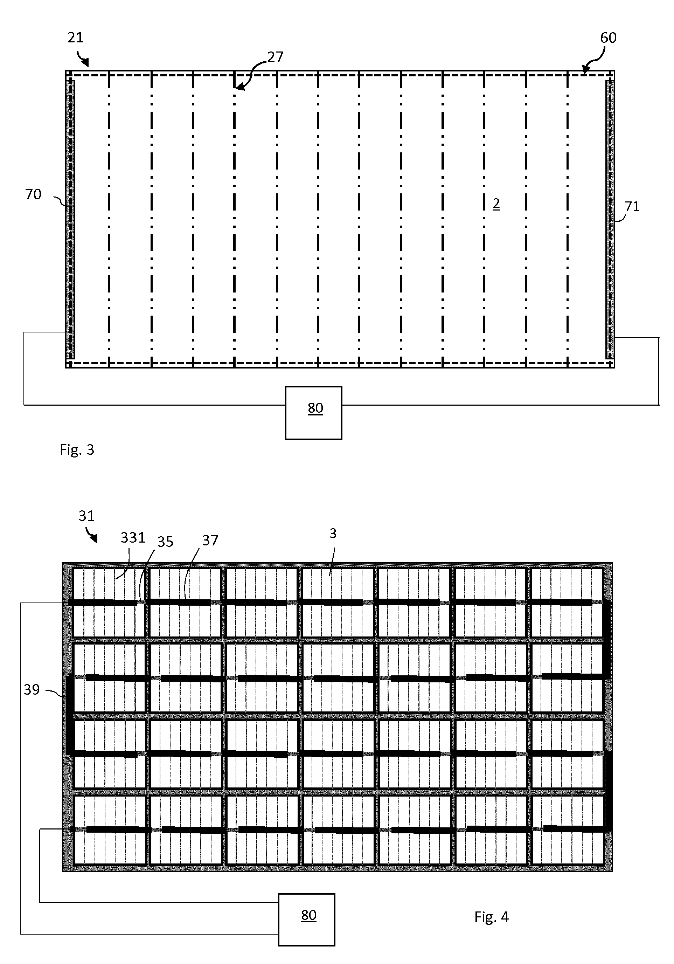

Fig. 3 illustrates a view from above of an embodiment according to that of Fig. 2, but with the thin film nanowire cell 2 divided into thirteen segments rather than the two shown in Fig. 2. Fig. 3 illustrates the first layer 21 and, in addition to prior annotations, an edge isolation 60 is formed, which cuts through the electrodes 23 and 24 as well as the dielectric 26. If it is desired to segment the cell 2 into parallel strings, additional horizontal cuts equivalent in nature to isolation 60 can be carried out. Connectors 70, 71 are added, connecting to each one of electrodes 23, 24 at the edges of the outermost cell segments, to enable wire connections to a junction box 80. Here, connections are completed either for a 2 wire or 4 wire out implementation, as will be discussed.

Fig. 4 illustrates a view from above of I the bulk solar cell layer 31 of an embodiment according to that of Fig. 2, including twenty-eight serially connected Si bulk solar cells 3. From Fig. 4 it is clear how a number of electrode fingers 331 extend from bus bar 35, on each Si bulk cell 3. Conductive wiring 37 is provided to serially connect adjacent bulk cells 3, preferably to the bus bar 35 at the upper electrode. Furthermore, connectors 39 are used to connect multiple strings of bulk cells 3 together, as is conventional for Si modules. Connections to the junction box 80 are also indicated, which may also be accomplished by means of metal wiring similar to the connector 39.

A consequence of the stacked photovoltaic device according to the described embodiments is that a large portion of photons received, within the higher frequencies of the spectral region, are absorbed in the thin film cells 2 of the upper layer 21. As a result, a lower current will be generated in the lower layer 31 bulk solar cells 3, than for conventional Si cells. A positive effect of this is that it is possible to increase the spacing between the fingers 331 in the upper bulk cell electrode, and that there is a potential for using fewer bus bars 34 and wires 37. Such electrodes and wires are normally formed of silver solders, and decreased use will actually reduce cost.

In one version of the embodiment shown in Fig. 1, the thin film solar cell 2 and the bulk solar cell 3 may be electrically separate. In other words, the two layers 21, 31 may act as two separate systems with four leads out producing power separately, and being connected in series only optically. Separate connections may thus be provided to the electrodes 23, 24, 33, 34, which may be wired to the junction box 80 for further handling, such as DC/AC conversion. Alternatively, plural thin film solar cells 2 may be serially connected, and separately plural bulk solar cells may be serially connected to each other. An example of such an embodiment is represented by the device shown in Figs 2-4. In standard solar cell installations, adjacent solar cells oriented in one plane are normally connected into a solar cell panel or module. Solar cells are usually connected in series in modules, creating an additive voltage. As an alternative, cells may be connected in parallel, which yields a higher current. However, shadow effects can shut down a less illuminated parallel string of a number of series connected cells, causing substantial power loss and possible damage.

In another version of the embodiment of Fig. 1, the two optically stacked cells are also electrically connected to each other. Such a stacked module only needs two leads out that subsequently are connected to a conventional junction box 80. Such an embodiment may provide the benefit of creating a higher voltage, or a higher current, and to save connector material. Different variants of this type of embodiment will be described below.

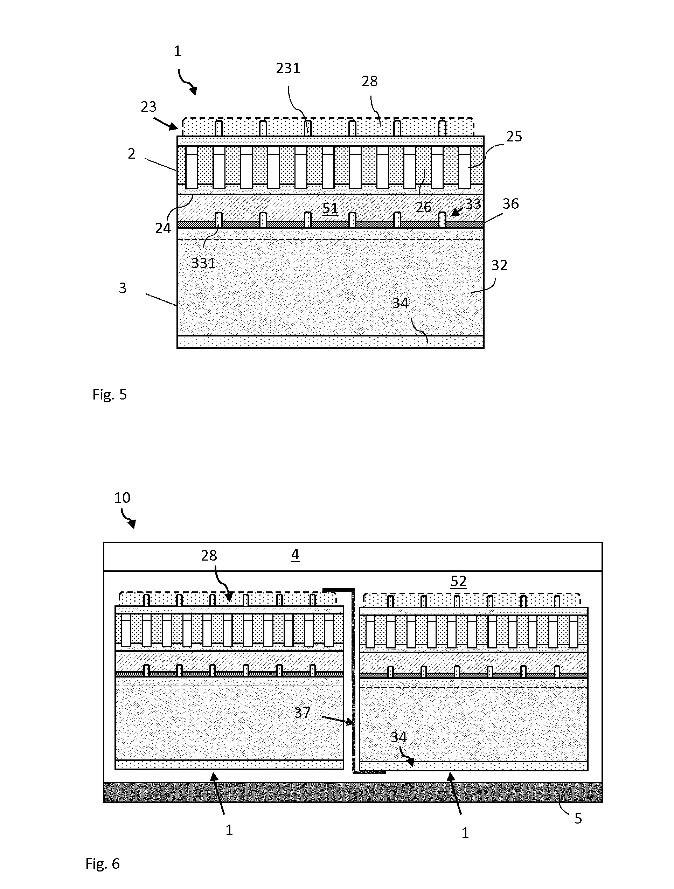

Fig. 5 illustrates an embodiment, in which one bulk solar cell 3 is electrically connected directly to one thin film cell 2. This will be referred to herein as a straight tandem, which is one embodiment of a photovoltaic device 1 according to the invention. In this embodiment, a single double-junction photovoltaic module is provided. While the top thin film solar cell shown in Fig. 5 is a nanowire array based cell 2, it should be understood that other types of thin film technologies may be used for forming the thin film solar cell 2, such as e.g. cadmium telluride (CdTe), copper indium gallium selenide (CIS or CIGS), amorphous silicon (a-Si) etc.

The thin film solar cell 2 shown in Fig. 5 comprises an array of nanowires 25, each characterized by at least one junction, and connected on one side of the junction to a top transparent electrode 23 and on the other side to a bottom transparent electrode 24, such that all the nanowires 25 in the array are connected in parallel. The top electrode 23 may comprise a transparent conducting oxide such as ITO with a thickness is in the range of 30-300 nm. An insulating dielectric 26 is present between the nanowires 25, and separating the top 23 and bottom 24 transparent electrodes. The dielectric 26 is transparent, preferably to most of the solar spectrum, and may be a polymer. The nanowire thin film cell 2 may e.g. be configured as outlined above with reference to Fig. 2.

The bottom bulk solar cell 3 may be a Si cell 3, having at least one junction (dashed). Also the Si bulk cell 3 may be configured as described with reference to Fig. 2. In the example shown in Fig. 5, the upper surface of the Si bulk material 32 is passivated by one or more dielectric layers 36, such as SiNx. Also the lower surface of the bulk material 32 may be passivated, e.g. by means of a layer of Al₂O₃ (not shown). A grid-structured electrode 33 is provided in the passivation layer 36, through which it forms contact with the bulk material 32. A complementary electrode 34 is connected at the lower surface of the bulk material 32, and may be formed by another grid-structure or a continuous electrode 34, as in the illustrated example. In the straight tandem configuration, the top electrode on the Si cell 3 comprises grid-like fingers 331.

In the tandem cell embodiment of Fig. 5, the top cell 2 and its bottom electrode 24 is connected to the top electrode fingers 331 of the Si cell 3, connecting the two cells 2, 3 in series. Connection may be formed by means of a conductive transparent connector 51, which may be composed of one or several layers of conductive materials, such as ITO, silver containing polymers, or other conductive polymers. Since the upper electrode 33 connects directly to the lower electrode 24 of the thin film cell 2, the electrode 33 may be formed without any bus bar. This means lower material cost and soldering time, and also decreases the shading effect of the metal conductor material. In an alternative variant of this embodiment, in which these advantages are further accentuated, conductive dots are disposed over the upper surface of the bulk cell 3, rather than fingers 331. In another variant of the embodiment of Fig. 5, a conductive material need only be provided between the two cells 2, 3 where the fingers 331, or dots, are present. Furthermore, this conductive material need not be transparent. Another material may then be present between the cells 2, 3, in between the conductive fingers or dots. This material should be transparent, but need not necessarily be conductive.

A thin film cell can typically be formed in any size, whereas bulk cells cut from ingots normally are restricted to a particular size. In the straight tandem embodiment of Fig. 5, the area of the thin film cell 2 is given by the area of the bulk cell 3, since the two are formed as one stacked element. Thus additional current spreading layers, e.g. a first grid structure 231 including fingers and a bus bar 28, may be added on top of the upper electrode 23 of the thin film cell 2. The current transport through the tandem is substantially vertical, and therefore substantially the same per surface area of the thin film 2 and Si cells 3. This may lead to problems with segmenting the top cell 2 in the straight stacked tandem cell, since the current output could be so high that the transparent connector 51 alone would suffer resistive losses. According to one embodiment, as shown in Fig. 5, this effect is minimized by adding a second grid structure connector 331 over the lower bulk cell, which substantially overlaps the first grid 231 vertically, which creates a low resistance connection. The overlap need not be total, but a corresponding spatial distribution of the grids 231, 331, such that they are vertically aligned, is advantageous from a loss perspective. Furthermore, it should be noted again that the drawings are not to scale. In reality, the width of each grid finger will normally be substantially larger than the thickness of the thin film cell 2. Placing the grid structures 231, 331 in an overlapping manner will thus also minimize any loss of output due to shading, since no added shading effect will be caused by the second grid structure 331, as it is already shaded by the first grid structure 231.

Fig. 6 illustrates an embodiment of a photovoltaic device according to the invention, in which two straight tandems 1 according to Fig. 5 are connected to each other into a tandem module 10. For the sake of simplicity, most references indicated in Fig. 5 are not repeated in Fig. 6. In the tandem module 10, the tandems 1 are serially connected, e.g. by means of a wire 37 running from the top electrode 23 of the thin film cell 2 of one tandem 1, to the lower electrode 34 of the bulk cell 3 of an adjacent tandem 1. In one embodiment, the wire 37 may connect a top bus bar 28 of the thin film cell of one tandem 1 to the bottom electrode 34 of the bulk cell of the next straight tandem 1. The straight tandems 1 are preferably embedded in some medium 52, such as EVA or vacuum, and protected by a front glass 4 and back sheet 5, similar to what was outlined with reference to Fig. 2. It should be noted that, although Fig. 6 only shows two straight tandems 1 in the module 10, such a module 10 may comprise many more straight tandems 1 connected in series, so as to obtain a higher voltage. Similar to what was shown in Fig. 4, the module 10 may include a plurality of strings (horizontal) of a number of interconnected straight tandems 1. Furthermore, those strings may be serially connected to each other by means of additional wiring 39 between the outermost tandems 1.

Past solutions for an optically stacked cell design have been based on multi-layer thin film design. One problem related to such designs, when devised for separate electrical connections to the stacked layers, is related to the thinness of the materials and the difficulties extracting the current between the layers. Solutions to this problem have included to use two mechanically separate thin film solar cells and then wire them together separately outside the cell. Electrical connection between solar cells provides an additional challenge, and when it comes to connection between solar cells of different types, this challenge is even greater due to the different electrical characteristics. Another suggested state of the art solution is the monolithically integrated cell, where a thin film cell consists of a number of layers that are mechanically and electrically connected. However, Kirchhoff's current law requires constant current - thus if one cell is designed so that it has higher stand-alone photocurrent than the other, there will be losses. Modern tandem cell designs usually utilizes an Esaki diode to interconnect the two diodes. This configuration has disadvantages that, in order to not lose efficiency, very tight current matching has to be performed for the two diodes and that optimal photocurrent matching can only be realized for a certain light input. These cells are thus much more difficult to produce. Another disadvantage of Esaki diodes are that they are high resistance devices.

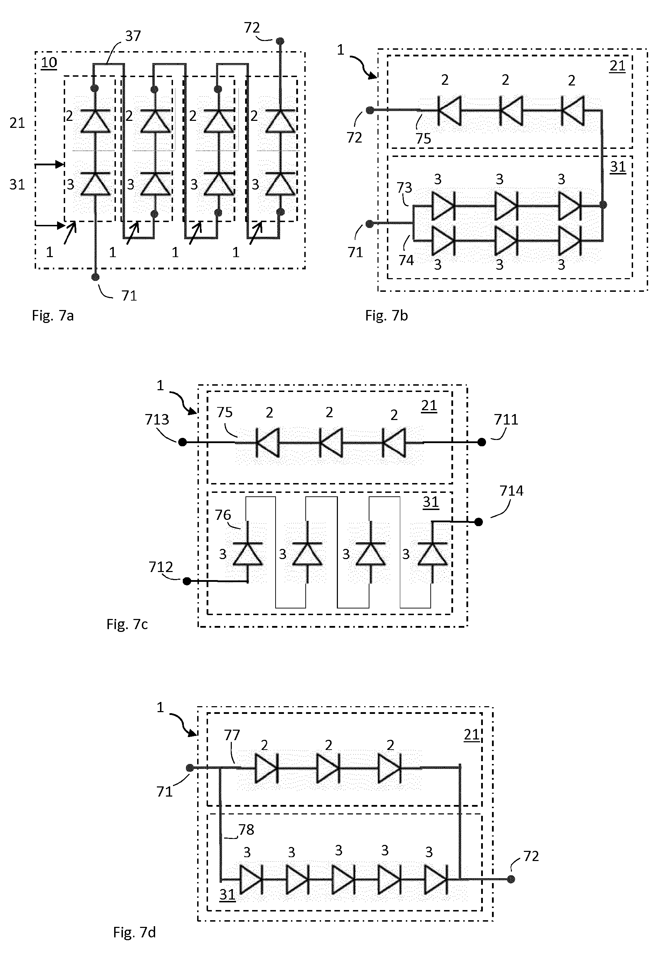

Figs 7a-d show, by way of example, different ways of electrically connecting the upper thin film cells 2 and lower bulk cells 3, in which each solar cell is visualized as a diode. Connectors are also shown for connection to a junction box (not shown).

Fig. 7a illustrates a module according to the embodiment of Fig. 6. In this embodiment, a number of thin film solar cells 2 are disposed in a first layer 21, and a number of bulk solar cells 3 are disposed in a lower layer 31. Each thin film solar cell 2 is positioned above one bulk solar cell 3, and these are pairwise electrically connected by means of a galvanic, ohmic, connection, meaning that a direct conduction path is permitted. This connection may correspond to the connection discussed with reference to Fig. 5, between electrodes 24 and 33. The outermost cells, i.e. the first and last cells in the serial chain, are provided with connectors 71, 72 for connection to a junction box 80 (not shown here).

In the embodiment of Fig. 7a, photocurrent matching may be required so as to minimize losses. In one embodiment, current matching is done by adjusting band gaps. In one example, a bulk Si cell 3 with bandgap of 1.12 eV could be current matched with a thin film solar cell 2 of band gap of approximately 1.7 eV. In reality one can achieve this by considering a ternary material such as GaAsP or AlGaAs by appropriate proportions of the group III elements. Another way of obtaining or contributing to photocurrent matching is to adjust a level of transparency in the thin film cells 2, e.g. by thinning layers. Using the Si bulk 3 example again, and a continuous film 2 of GaAs, one could use a thickness of 100-500 nm to achieve current matching. Other ways of regulating the transparency will be elaborated on further below.

Fig. 7b illustrates another embodiment, which is also a two wire 71, 72 out design. This design may include an embodiment according to the one described with reference to Fig. 2, i.e. where there is no direct built-in galvanic connection between optically stacked thin film cells 2 and bulk cells 3. However, as shown in Fig. 7b, additional connections, e.g. formed by separate wires, is used for connecting both cells to each other. This embodiment is configured to satisfy Kirchhoff's current law by appropriate laser scribing division of the top module 2 into appropriately sized segments. Such segments may be electrically connected by connections 27 or by separate wiring, either in series or parallel connections. In the example of Fig. 7b, three segments are serially connected into one string in the upper thin film cell layer 21. A corresponding connection arrangement can be done with bulk cells 3 in the lower layer 31, with the restriction that minimum current is given by one full wafer, if a wafer-type bulk cell 3 is employed. Due to the higher band gap in the thin film cells 2 than in the bulk cells 3, a greater voltage will be generated over a thin film cell 2 than over a bulk cell 3 when a photon is converted into free. Furthermore, in some embodiments the band gap of the thin film cell 2 is moderately higher than the band gap of the bulk cell 3. This means that predominantly all radiation of higher energy then the band gap of the thin film cell 2 is absorbed therein, whereas radiation having an energy ranging between the two band gaps will pass through the thin film 2 and be absorbed in the bulk cell 3. In one embodiment, the thin film 2 may be formed of GaAs, e.g. a planar GaAs layer or a nanowire-based cell as will be described below, configured over a Si bulk cell 3. Such a configuration would yield a higher current in the GaAs layer than in the Si, because the band gaps of Si and GaAs are too similar. In accordance with the embodiment of Fig. 7b, this imbalance is at least partly overcome by strategic connection between the cells 2, 3. In the shown example, two strings 73, 74 of serially connected bulk cells 3 are connected in parallel. This parallel coupling is in turn serially connected to one string 75 of thin film cells. This way photocurrent matching can be greatly simplified, compared to the use of Esaki diodes, by means of galvanic connections and simple electronic design. This approach also reduces use of expensive pastes since thin film segmentation reduces the need for fingers on the top module, compared to the straight tandem design. As noted, this particular connection example of Fig. 7b would be appropriate if the current in the top string 75 module corresponds to that of two Si strings 73, 74 in parallel. For fine tuning, the distance between series connections 27 between separate thin film segments 2 can be adjusted within some limits, or other segmenting of the top or bottom modules can be considered. It should also be noted that more than two strings of cells 3 may be connected in parallel. By the general design principle discussed with reference to Fig. 7b, it will be understood that current matching can at least partly be obtained by simple calculations and suitable connections.

Fig. 7c illustrates a basic 4-wire out embodiment of the stacked photovoltaic device 1, corresponding the embodiments of Figs 2-4. In this embodiment, several thin film cells are connected in series in a string 75, whereby the outermost cells 2 are provided with connectors 711, 713 for connection to the junction box. Similarly, a number of bulk cells 3 are serially connected in a string 76, provided with separate connectors 712, 714 for connection to a junction box, which may be the same or another, as the junction box to which the thin film cells 2 are connected. If both strings 75, 76 are connected to the same junction box, additional electronics may be provided therein for current matching and other adaptation. Alternatively, the bulk cells 3 and thin film cells 2 may exist off grid, simply having them supply two different battery banks.

Another embodiment is illustrated in Fig. 7d. While the embodiments of Figs 7a-b were directed to photocurrent matching, the embodiment of Fig. 7d is directed to voltage matching. A first number of thin film cells 2 are connected in series in a string 77. In addition, a second number of bulk cells 3 are serially connected in a string 78. As noted, each thin film cell 2 is configured to provide a higher voltage than the bulk cells 3, due to the larger band gap. However, by careful selection of the first and second number of cells in the two strings 77, 78, approximately the same voltage can be obtained over the two strings 77, 78, thus obtaining voltage matching. These two strings 77, 78 may thus be connected in parallel to each other, as shown in the drawing. This way, a two wire out solution is obtained, with connectors 71, 72 for connection to a junction box.

By utilizing galvanic interconnects between the diodes in a thin film-bulk hybrid solar cell configuration, it is possible to eliminate the use of high resistance Esaki diodes. Furthermore, the need for current matching can be appreciably limited or, depending on circuit configuration, entirely eliminated, while retaining a low number of electrode grid connections.

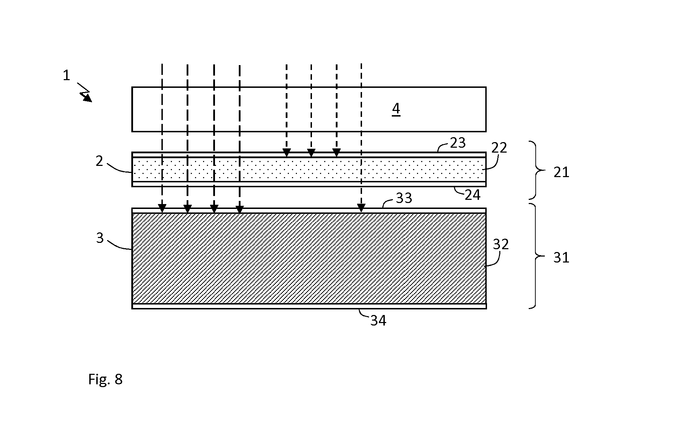

A further embodiment, which may be employed in combination with any one of the aforementioned embodiments, will now be described with reference to Fig. 8. As in the embodiment of Fig. 1, the embodiment of Fig. 8 relates to a photovoltaic device 1, which includes a thin film solar cell 2 disposed in a first layer 21, which is configured to be arranged closes to the sun. The thin film solar cell 2 comprises at least one junction with a first band gap corresponding to a first spectral range. A bulk solar cell 3 is disposed in a second layer 31, positioned below the first layer 21, i.e. configured to be arranged furthest from the sun of the two layers 21, 31. The bulk solar cell 3 includes at least one junction having a second band gap, being smaller than the first band gap of the first layer, and corresponding to a second spectral range. Furthermore, the thin film solar cell 2 is at least partly transparent to light within the second spectral range. More specifically, since the thin film solar cell 2 will be capable of generating charged carriers by absorbing photons having a frequency corresponding to the thin film cell band gap and higher, the first layer 21 is preferably completely transparent (or to as high level as possible) to at least all spectral frequencies in the range between the band gap of the thin film cells 2 and the band gap of the bulk cells 3. This goes for all embodiments described above too. In Fig. 8 this is illustrated by means of dashed vertical arrows, representing impinging light, such as sunlight, within the second spectral range. Such light will preferably pass the thin film cell 2 without any absorption, and subsequently be absorbed in the underlying bulk cell 3, where its energy is at least partly converted into electric energy.

In addition to the transparency to spectral frequencies below the band gap of the thin film cell 2, the thin film cell 2 in the upper layer 21 is preferably also at least partly transparent to light of the first spectral range, i.e. to light of frequencies corresponding to or higher than the band gap of the thin film solar cells 2. This is indicated in the drawing of Fig. 8 by means of finer dashed vertical arrows, representing impinging light within the first spectral range. More specifically, one of the arrows of the first spectral range passes through the thin film cell 2 to the bulk cell 3. This embodiment thus differs from normal stacked solar cell design, in that the thin film solar cell 2 is deliberately configured to have a certain level of transparency to light over its band gap, which level is more than zero. More specifically, in preferred embodiments of a photovoltaic device 1, in which the thin film cell 2 is serially connected to the underlying bulk cell 3, the thin film cell 2 is deliberately configured to have a certain level of transparency, so as to contribute to photocurrent matching. In any stacked tandem cell, i.e. where we place materials of different band gaps one on top of the next with the highest band gap on top, regardless of whether the cells are connected in series or not, there is a general design principle that one always wants to optimize the topmost cell first and make sure we absorb as much light as we can in that cell. The design principle and embodiments presented here with reference to Fig. 8 thus represent a concept that goes against normal principles. This transparency may be obtained by partitioning the thin film cell 2 throughout the first layer 21, so as to obtain a certain level of transparency between thin film segments. 3. In such an embodiment, the thin film cell 2 in the first layer 21 comprises absorbing regions and non-absorbing regions, such that a portion of an incident photonic wave-front will pass through the non-absorbing region to the second layer 31 of bulk cells 3. The level of transparency, or the magnitude of the portion of the incident photonic wave-front that passes through the first layer 21, may be dependent on a lateral density of the absorbing regions. Preferably, the partitioning into these absorbing and non-absorbing regions is deliberately configured so as to obtain a predetermined level of transparency in the first layer 21 to light of the first frequency range. One way of obtaining this partitioning into absorbing, i.e. active, regions and non-absorbing regions is to employ a thin film cell 2 of nanowires, provided with a selected surface density, or lateral density. Such nanowires may be clustered to form an absorbing region, with intermediate non-absorbing regions. In an alternative embodiment, each nanowire may be considered as one absorbing region, whereas the space between the nanowires represents non-absorbing regions. In an alternative embodiment, thinning the top cell so as to obtain a level of transparency may be performed. In another embodiment the thin film cell may be formed as a quantum dot cell, in which the transparency may be controlled by means of either the amount of quantum dots included in the film, the distribution of such quantum dots, or both. Each quantum dot, or a surface region covered with quantum dots, could then define an absorbing region.

Configuring the thin film cell 2 layer 21 so as to have a certain level of transparency to photons it is also configured to absorb, may be employed in preferred embodiments of a photovoltaic device 1, in which the thin film cell 2 is serially connected to the underlying bulk cell 3. In such embodiments, the thin film cell layer 21 may deliberately be configured to have a certain level of transparency, so as to contribute to photocurrent matching. In other embodiments, the thin film layer 21 is configured to have a certain level of transparency regardless of whether there is any serial connection between the thin film cells 2 and bulk cells 3. This will be described further below.

In a preferred embodiment, the thin film cell 2 is a nanowire array based solar cell. Such a type of thin film cell is partitioned in its design, due to the spacing between nanowires in a nanowire array. The top nanowire cell 2 may comprise a periodic or aperiodic array of vertically aligned semiconductor nanowires 25 made of e.g. GaAs, AlGaAs, InP, or alloys thereof, as described with reference to Fig. 2. Both the upper 23 and lower 24 electrodes of the nanowire cell 2 are thus transparent. Other examples of such nanowire-based solar cells can e.g. be found in applicant's own co-pending applications PCT/US13/73581 and SE1350687-8.

According to some models, a nanowire solar cell 2 can never have perfect absorption, unlike a planar film. In an embodiment as that of Fig. 8, this also becomes an advantageous distinguishing feature of such a cell 2, when used in a stacked cell approach. In traditional tandem cell design, based on multi-junction thin film cells, one fundamental design principle is to maximize absorption in the material with the highest band gap, i.e. the top cell, and do current matching by adjusting the properties of the underlying cell. Further, in a planar film, attempting to achieve photocurrent matching by thinning the top cell is not arbitrary, since films must be of some minimum thickness to function. However, in a nanowire array, the level of transparency can be adjusted by e.g. varying the nanowire spacing when the cell 2 is formed.

In fact, an additional technical effect may be obtained with the embodiment of Fig. 8, for the specific variant in which the thin film cell 2 is a nanowire-based solar cell 2. The surface area of a nanowire-based solar cell has a highly limiting effect on the voltage V_{OC} and the fill factor FF of the cell, and is thus strongly limiting for its efficiency. In addition, the amount of material used in the nanowires also determines the surface concentration level of photons in the p-n junction. By lowering the surface density of nanowires 25, there will be fewer threads in a cell of a certain dimension, with larger spacing between the nanowires 25. Since the envelope surface of the nanowires 25 contributes to a large extent to the cell surface, an increased nanowire spacing also means that the total surface area decreases. In addition, less semiconductor material will be used. This increases the V_{OC} and the FF, and thus the relative efficiency of the cell. For a single junction nanowire-based solar cell, this effect is of minor importance, since it is counteracted by fewer photons being absorbed. However by stacking a nanowire-based solar cell 2 over a bulk solar cell 3 with a lower band gap, the photons missed in the upper cell 2 may can be taken care of the efficiently in the bulk cell 3, even if a lower voltage will be obtained in the bulk cell 3 than in the nanowire cell 2. As a result, design optimum for the actual efficiency may actually be offset compared to a non-transparent thin film. In other words, in an optimized embodiment according to Fig. 8, taking into account that photons missed in the thin film cell 2 are captured in the bulk cell 3, the nanowire spacing will be larger, meaning a higher level of transparency, than in an optimized single junction nanowire solar cell. In an embodiment, in which the nanowire cell 2 is serially connected with the underlying bulk cell 3, the nanowire spacing may be increased even more than what would be the case only for the purpose of optimizing conversion efficiency, for the purpose of photocurrent matching.

In fact, configuration has a technical effect which is relevant even in the case where current matching is not an objective, such as e.g. in the embodiment of Fig. 7c. Nanowires are comparatively expensive, and have a certain sweet spot in terms of length. The additional boost by filling up the thin film layer 21 with tightly packed nanowires costs more than the benefit in efficiency, and the cell will look more like a planar thin film cell. The absorption in the top cell 2 is not a linear function of volume for nanowires, it is a game of diminishing returns. As noted, the voltage and fill factor of the top cell improves if we reduce the amount of material below what is optically ideal. So the actual performance optimum is not the same as the optical optimum. In particular for nanowire cells, the surfaces limit performance and surface area is proportional to the number of wires. When a partly transparent nanowire-based layer 21 is configured over a Si bulk layer 31, an "optically optimized" case may have about 2.5 times the surface area of the completely current matched case, which results in a significant change in FF and Voc. On the other hand, planar cells have a surface area independent of thickness.

In a preferred embodiment, the bulk cell 3 is a Si bulk cell 3, which has tremendous economical weight in todays' solar cell market. Furthermore, there is a big value in the constraint that the bottom cell is made of Si, namely that rather than optimizing tandem cells from scratch, nanowires provide a means for easily optimizing things in a new way.

The level of transparency to photons with energy higher than the band gap of the nanowire thin film 2 will depend on many parameters, including material choices, specific electrical connections, etc. However, exemplary levels of transparency may be up to 5%, up to 10%, or even higher.

It should be noted that configuring the thin film cell 2 so as to have a certain level of transparency to light it is also configured to absorb, need not be the sole measure taken to contribute to photocurrent matching. Rather, this design feature may be employed in combination with selected electrical coupling according to Figs 7a-d, or with band gap adjustment. It will also be evident from the above that the combination of a partly transparent nanowire-based thin film solar cell 2 with an optically stacked bulk solar cell 3 provides a technical effect even without serial interconnection, due to the possibility of balancing an increased energy efficiency in the thin film cell 2 with increased absorption in the bulk cell 3. In fact, even if several embodiments have been described in the foregoing, it will be quite clear to the skilled reader that those embodiments may be combined, in the sense that distinguishing features of one embodiment may be combined with distinguishing features of other embodiments, unless they are de facto contradictory. It will furthermore be evident that various modifications of the general and specific embodiments disclosed may be carried out, without departing from the scope defined by the appended claims.

## Claims

1. A hybrid photovoltaic device (1) comprising
a thin film solar cell (2) disposed in a first layer (21), having a junction with a first band gap corresponding to a first spectral range;
a bulk solar cell (3) disposed in a second layer (31), positioned below the first layer (21), having a junction with a second band gap, which is smaller than said first band gap and corresponding to a second spectral range.

2. The hybrid photovoltaic device of claim 1, wherein said thin film solar cell (2) is at least partly transparent to light within said first spectral range.

3. The hybrid photovoltaic device of claim 1 or 2, wherein said first layer (21) comprises absorbing regions and non-absorbing regions, such that a portion of an incident photonic wave-front will pass through the non-absorbing region to the second layer.

4. The hybrid photovoltaic device of claim 3, wherein said portion of the incident photonic wave-front is dependent on a lateral density of the absorbing regions.

5. The hybrid photovoltaic device of any of the preceding claims, wherein said first layer (21) is configured to have a predetermined level of transparency to light of said first spectral range.

6. The hybrid photovoltaic device of any of the preceding claims, wherein the thin film solar cell is serially connected to the bulk solar cell through a galvanic connection between a thin film electrode (24) and a bulk electrode (33).

7. The hybrid photovoltaic device of claim 5 and 6, wherein said level of transparency to light of the first spectral range is configured so as to contribute to photocurrent matching between the thin film solar cell and the bulk material solar cell.

8. The hybrid photovoltaic device of any of the preceding claims, wherein said thin film solar cell is a nanowire solar cell comprising an array of vertically aligned nanowires (25).

9. The hybrid photovoltaic device of claim 8 and 5, wherein a surface density of nanowires is limited so as to obtain said level of transparency.

10. The hybrid photovoltaic device of claim 8, wherein the material of the nanowires in the film cell is a direct band gap semiconductor such as, GaAs, AlGaAs, InP, or alloys thereof.

11. The hybrid photovoltaic device of any of the preceding claims, wherein the bulk solar cell is made of Si or CIGS.

12. The hybrid photovoltaic device of any of the preceding claims, wherein the first band gap is adjusted so as to contribute to photocurrent matching between the thin film solar cell and the bulk solar cell.

13. The hybrid photovoltaic device of claim 6, wherein said galvanic connection also connects to an electrode of a second bulk solar cell such that said bulk solar cells are connected in parallel (73, 74) to each other and in series (75) to said thin film solar cell, so as to contribute to the photocurrent matching between the thin film solar cell and the bulk solar cells.

14. The hybrid photovoltaic device of claim 6, wherein a first number of thin film solar cells are serially interconnected into a first string of thin film cells (77), and a second number of bulk solar cells are serially interconnected into a second string (78) of bulk solar cells, which first and second strings are connected in parallel, and wherein said numbers of cells in the strings are adapted so as to contribute to voltage matching.

15. The hybrid photovoltaic device of any of the preceding claims, comprising a conductive layer (51) positioned between the first layer and the second layer, galvanically connecting an electrode of the thin film solar cell with an electrode of the bulk solar cell.

16. The hybrid photovoltaic device of claim 3, wherein a first connector grid structure (231) is connected at an upper face of the thin film solar cell, and wherein said galvanic connection comprises a second grid structure (331), and wherein said first and second grid structures (231, 231) substantially overlap vertically.

17. The hybrid photovoltaic device of claims 16, wherein said grid structure is positioned between the first layer and the second layer, common for the thin film solar cell and the bulk material solar cell.
